Europäisches Patentamt

European Patent Office

Office européen des brevets

(11) Numéro de publication: **0 426 526 A1**

## DEMANDE DE BREVET EUROPEEN

(21) Numéro de dépôt: **90402978.2**

(22) Date de dépôt: **23.10.90**

(51) Int. Cl.5: **H03K 19/173**

(30) Priorité: **31.10.89 FR 8914288**

(43) Date de publication de la demande:
**08.05.91 Bulletin 91/19**

(84) Etats contractants désignés:
**DE GB NL**

(71) Demandeur: **THOMSON COMPOSANTS MICROONDES**
**51, Esplanade du Général de Gaulle**
**F-92800 Puteaux(FR)**

(72) Inventeur: **Gobbi, José Maria**
**THOMSON-CSF, SCPI, Cédex 67**
**F-92045 Paris la Défense(FR)**
Inventeur: **Le Berre, Louis**
**THOMSON-CSF, SCPI, Cédex 67**
**F-92045 Paris la Défense(FR)**

(74) Mandataire: **Taboureau, James et al**
**THOMSON-CSF SCPI**
**F-92045 Paris La Défense Cédex 67(FR)**

(54) **Circuit intégré logique prédiffusé comportant au moins un amplificateur.**

(57) L'invention concerne un circuit intégré logique prédiffusé, dont une partie est transformée en circuit analogique.

Un circuit logique prédiffusé comprend une pluralité (le cellules logiques (3), formées chacune par des transistors de signaux (7-11) non câblés. S'il est nécessaire d'augmenter la sortance d'une porte logique, les transistors d'une cellule logique voisine sont montés en parallèle, au moins deux transistors de signaux (7,8) pour en faire un transistor amplificateur, et au moins deux transistor( (9,10) pour en faire une source de courant pour cet amplificateur. Cette transformation s'effectue au cours des métallisations finales de personnification du circuit prédiffusé.

Application aux circuits logiques rapides.

FIG_3

EP 0 426 526 A1

# CIRCUIT INTEGRE LOGIQUE PREDIFFUSE COMPORTANT AU MOINS UN AMPLIFICATEUR

La présente invention concerne la transformation partielle d'un circuit intégré logique prédiffusé, ainsi que le circuit intégré transformé dans lequel les transistors d'une ou plusieurs cellules logiques sont utilisés pour réaliser un amplificateur de puissance, situé parmi les cellules logiques.

On sait que les circuits intégrés prédiffusés sont des circuits qui comportent des composants, simples tels que les transistors ou plus complexes telles que les portes logiques, non interconnectés entre eux. Ce sont des circuits non spécifiques, qui sont personnalisés selon les besoins des utilisateurs, au moyen d'une ou plusieurs métallisations d'interconnexions.

Las circuits prédiffusés ont cependant, dès leur conception, une certaine orientation : les uns sont conçus pour en faire des circuits analogiques, d'autres sont conçus pour en faire des circuits logiques. Dans le cas des circuits logiques, les transistors prédiffusés ont des caractéristiques de faible bruit et faible puissance, de sorte qu'il faut entourer le "coeur" logique de la pastille de matériau semiconducteur d'une ceinture de circuits d'interfaces, amplificateurs.

Si une porte logique doit posséder une sortance importante, soit parce qu'elle est adressée sur une pluralité d'autres portes, soit parce qu'elle est réunie une longue connexion, il faut alors sortir du "coeur" de la pastille pour amplifier les signaux par un circuit dit "buffer" puis ré-entrer dans le "coeur" vers les portes logiques. Il n'y a pas optimisation des interconnexions, et les longues connexions atténuent les signaux, ou interfèrent.

Le procédé selon l'invention consiste à utiliser, dans un circuit intégré prédiffusé logique, les transistors de signaux d'une cellule logique, et à les interconnecter de façon en faire un amplificateur. Las circuits intégrés logiques selon l'invention sont caractérisés par la présence, au sein d'une "mer de portes", c'est à dire au coeur de la pastille, d'au moins un amplificateur, relié aux portes logiques voisines par des interconnexions directes et courtes.

De façon plus précise, l'invention concerne un circuit intégré logique prédiffusé, comportant, sur une pastille de matériau semiconducteur, une région centrale constituée de cellules logiques dont chacune est formée par une pluralité de transistors de signaux adaptés à la réalisation de portes logiques, ce circuit intégré étant caractérisé en ce que, en vue d'augmenter la sortance d'une porte logique, il comporte dans sa région centrale au moins un amplificateur réalisé au moyen des transistors de signaux d'au moins une cellule logique par montage en parallèle des dits transistors de signaux.

L'invention sera mieux comprise par la description qui suit de deux exemples de réalisation, en liaison avec les figures jointes en annexe, qui représentent :

- figure 1 : vue schématisée d'une pastille de circuit intégré prédiffusé, et agrandissement d'une cellule logique non câblée, selon l'invention.
- figure 2 : premier exemple de transformation d'une porte logique en amplificateur, selon l'invention,
- figure 3 : second exemple de transformation d'une porte logique en amplificateur, selon l'invention.

Les circuits intégrés personnalisables sont dits prédiffusés lorsqu'ils sont en silicium, ou préimplantés lorsqu'ils sont en GaAs ou matériaux semiconducteurs du groupe III-V, puisqu'on ne fait pas de diffusions sur ces matériaux. Toutefois, afin de simplifier le texte, le terme "prédiffusé" sera seul utilisé, sans restriction sur la portée de l'invention qui couvre tous les matériaux semiconducteurs.

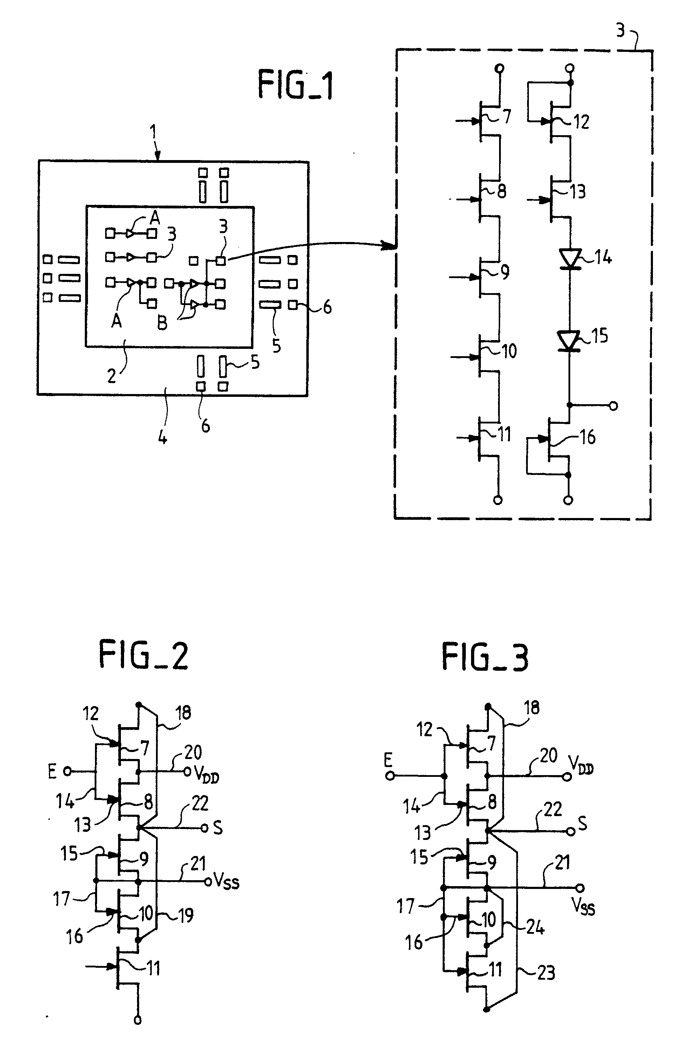

Un circuit intégré prédiffusé logique est très schématiquement représenté sur la partie gauche de la figure 1. La puce 1 du circuit comprend un "coeur", ou partie centrale 2, constitué d'un réseau, ou damier, de cellules 3 capables de remplir certaines fonctions logiques après qu'elles aient été personnalisées, c'est à dire qu'elles aient reçu les métallisations nécessaires. La périphérie de la puce comporte une ceinture 4 de circuits interfaces 5 et de plots de câblage 6. Les interfaces 5 sont soit d'entrées/sorties, soit d'amplification interne ou externe.

Sur la partie droite de la figure 1 est agrandie une cellule prédiffusée 3, entourée symboliquement par une ligne pointillée. Elle contient, par exemple, une pluralité de transistors 7 à 11, et un étage décaleur composé de deux transistors 12 et 13, deux diodes de décalage 14 et 15 et une source de courant 16. Dans cet état du circuit prédiffusé, les liaisons ne sont pas câblées par des métallisations, de sorte que ces cellules, qui sont toutes identiques, peuvent être transformées en inverseurs ou en différentes portes, ET, ET-NON..., à différents nombres d'entrées ou en combinaisons de portes.

Selon le schéma de l'utilisateur, et malgré une recherche d'optimisation des réseaux de métallisations, le taux d'utilisation des cellules prédiffusées n'est jamais égal à 100 % : des cellules sont inutilisées. Mais il est aussi fréquent qu'une porte ait, compte tenu (le la nature des transistors de signaux, une sortance insuffisante : soit que cette porte attaque plusieurs portes, soit qu'elle soit réunie à une autre porte par une longue métallisation, ce qui entraîne une capacité parasite. Dans ce cas, il faut amplifier le signal de sortie pour obtenir la sortance nécessaire : selon l'art connu, on utilise les amplificateurs 5 qui sont disposés sur la ceinture 4 qui entoure la pastille de circuit prédiffusé. Mais ceci entraîne des liaisons longues entre le coeur de la pastille et la ceinture.

Selon l'invention, les transistors de signaux d'une ou plusieurs cellules logiques prédiffusées, (dans le coeur de la pastille, sont utilisés et câblés pour les transformer en amplificateurs de puissance. Ces amplificateurs sont donc situés au sein d'un réseau logique, et chacun d'entre eux est réuni à la sortie d'une porte logique par une liaison courte, donc ni capacitive, ni parasitée. Ceci est possible puisque les cellules logiques prédiffusées ne sont pratiquement jamais utilisées à 100 %. Sur la figure 1, quelques cellules logiques transforméés en amplificateurs sont désignées par la lettre A.

Considérons une cellule logique prédiffusée telle que celle de la figure 1 : seuls les transistors d'entrée 7 à 11 sont utilisés, et l'étage de sortie n'est pas utilisé pour la transformer en amplificateur. Si le schéma de cette cellule logique avait une autre architecture (BFL, LPFL, DCFL...), cela ne modifierait pas l'invention dont la base consiste à regrouper des transistors de signaux pour en obtenir une petite puissance. Deux exemples en sont donnés en figures 2 et 3.

Dans un circuit prédiffusé logique, les transistors sont groupés en lignes, et la région située entre deux grilles constitue la source d'un premier transistor et le drain d'un second transistor. Pour grouper deux transistors en parallèle, on prend cette région commune comme première électrode d'accès, tandis que les deux régions extrêmes, c'est à dire le drain du premier transistor et la source du deuxième transistor sont réunies par une métallisation. Les deux grilles sont réunies par une autre métallisation.

Ainsi, sur la figure 2, la ligne de transistors 7,8... 11 présente une suite de régions communes drains-sources entre chacun des transistors de signal. Pour en faire un amplificateur, les grilles sont regroupées : la grille 12 du premier transistor 7 et la grille 13 du second transistor 8 sont réunies par une métailisation 14 qui constitue l'entrée E de l'amplificateur. De la même façon la grille 15 du troisième transistor 9 et la grille 16 du quatrième transistor 10 sont réunies par une métallisation 17. Par ailleurs, le drain du premier transistor 7 est réuni à la source du second transistor 8 par une métallisation 18, et le drain dit troisième transistor 9 est réuni à la source du quatrième transistor 10 par une métallisation 19.

L'alimentation de cet amplificateur est assurée par une tension $V_{DD}$ appliquêe par une métallisation 20 au point commun entre les premier et second transistors 7 et 8, et par une tension $V_{SS}$ appliquée par une métalisation 21 au point commun entre les troisième et quatrième transistors 9 et 10. La métallisation 21 est en contact avec la métallisation 17, puisque les transistors 9 et 10 sont des sources de courant en parallèle. La sortie S de l'amplificateur est prise sur une métallisation 22 au point commun entre tes deuxième et le troisième transistors 8 et 9, c'est à dire entre le transistor d'entrée 7 + 8 et sa source de courant 9 + 10.

Cette architecture suppose que le nombre de transistors utilisé est pair. En fait, si la cellule logique transformée en amplificateur comprend un nombre impair de transistors, par exemple 5 comme représenté, le transitor 11, inutilisé mais couplé par les régions prédiffusées, apporte une capacité parasite en parallèle sur la sortie.

Une autre architecture est préférable si le nombre de transistors utilisés est impair : elle est représentée en figure 3. Il n'y a pas de changement pour le transistor d'entrée constitué des deux transistors 7 et 8 montés en parallèle, ni pour les alimentations $V_{DD}$ et $V_{SS}$ et pour la sortie S. Mais la source de courant est constituée par les trois transistors 9, 10 et 11, dont les trois grilles sont réunies et qui sont montés en parallèle pris deux à deux, par les métallisations 23 et 24. Selon cette architecture , la capacité parasite du cinquième transistor 11 est en parallèle sur l'alimentation, et non plus sur la sortie.

De façon plus générale, la puissance de cet amplificateur peut être augmentée en montant en paralèlle plus de deux transistors dans une même cellule prédiffusée 3. A titre d'exemple, la puissance de l'amplificateur de la figure 3 peut être multipliée par un facteur "n" en montant en parallèle "n" cellules logiques -voisines sur la pastille de circuit intégrécâblêes en amplificateur selon l'invention. Sur la figure 1, un amplificateur constitué par deux cellules logiques transformées en amplificateur à deux étages en parallèle est désigné par la lettre B.

L'intérêt de cette invention rêside en ce qu'elle permet d'implanter des amplificateurs en un point quelconque d'un circuit logique, avec des liaisons courtes, puisque ce sont certaines cellules logiques qui sont transformées en amplificateur.

## Revendications

1 - Circuit intégré logique prédiffusé, comportant, sur une pastille (1) de matériau semiconducteur, une région centrale (2) constituée de cellules logiques (3) dont chacune est formée par une pluralité de transistors de signaux (7-11) adaptés à la réalisation de portes logiques, ce circuit intégré étant caractérisé en ce que, en vue d'augmenter la sortance d'une porte logique, il comporte dans sa région centrale (2) au moins un amplificateur (A) réalisé au moyen des transistors de signaux (7-11) d'au moins une cellule logique (3)f, par montage en parallèle des dits transistors de signaux (7 + 8, 9 + 10).

2 - Circuit intégré selon la revendication 1, caractérisé en ce que, une cellule logique comportant au moins quatre transistors de signaux (7-10), celle-ci est transformée en amplificateur en montant en parallèle deux premiers transistors (7,8) pour former un transistor d'entrée de puissance, et en montant en parallèle deux seconds transistors (9,10) pour former une source de courant de puissance.

3 - Circuit intégré selon la revendication 1, caractérisé en ce que, une cellule logique comportant un nombre impair de transistors (7,11), celle-ci est transformée en amplificateur en montant en parallèle un nombre pair de premiers transistors (7,8) pour former un transistor d'entrée de puissance, et en montant en parallèle un nombre impair de seconds transistors (9,10,11) pour former une source de courant de puissance.

4 - Circuit intégré selon la revendication 1, caractérisé en ce qu'il comporte au moins un amplificateur (B) réalisé au moyen d'au moins deux cellules logiques (3) montées en parallèle, les transistors (7-11) de chacune des cellules (3) étant eux-mêmes montés en parallèle, en amplificateurs.

5 - Circuit intégré selon la revendication 1, caractérisé en ce qu'il comporte, situé parmi des portes logiques, au moins un circuit analogique amplificateur, réuni aux portes logiques par des métallisations courtes.

FIG_1

FIG_2

FIG_3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | IEEE JOURNAL OF SOLID-STATE CIRCUITS, vol. SC-19, no. 5, octobre 1984, pages 728-738, IEEE, New York, US; R.N. DEMING et al.: "A gallium arsenide configurable cell array using buffered FET logic" * Figure 2; page 730, colonne de gauche, lignes 22-28 * | 1,2 | H 03 K 19/173 |
| A | IEEE GaAs IC SYMPOSIUM, Boston, MA, 23-25 octobre 1984, pages 15-18, IEEE, New York, US; R.N. DEMING et al.: "A gallium arsenide configurable cell array using buffered FET logic" * Figure 1; page 15, colonne de droite, lignes 9-13; page 16, colonne de gauche, lignes 4-6 * | 1,2 | |
| A | E.D.N. ELECTRICAL DESIGN NEWS, vol. 27, no. 22, novembre 1982, pages 113-117, Boston, MA, US; R. PATE et al.: "Observe simple design rules when customizing gate arrays" * Figure 3 * | 4 | |
| A | PATENT ABSTRACTS OF JAPAN, vol. 11, no. 217 (E-523)[2664], 14 juillet 1987; & JP-A-62 35 716 (HITACHI LTD) 16-02-1987 * Figure; page (E-523)[2664] * | 1 | **DOMAINES TECHNIQUES RECHERCHES (Int. Cl.5)** |
| P,A | EP-A-0 360 164 (NATIONAL SEMICONDUCTOR CORP.) * Figures 4,5; colonne 3, ligne 41 - colonne 4, ligne 19 * | 1 | H 03 K |

Le présent rapport de recherche a été établi pour toutes les revendications

| Lieu de la recherche | Date d'achèvement de la recherche | Examinateur |
|---|---|---|
| La Haye | 28 janvier 91 | FEUER F.S. |